# EUROPEAN PATENT APPLICATION

(11) **EP 3 758 184 A1**
(43) Date of publication of application: **30.12.2020**
(21) Application number: 19183210.4
(22) Date of filing: 28.06.2019
(51) Int. Cl.: H02J 7/00, A24F 1/00, H05K 7/20

(54) **CHARGING DEVICE AND SMOKING SUBSTITUTE KIT**

(71) Applicant: NERUDIA LIMITED, Liverpool Merseyside L24 9HP (GB)
(72) Inventor: The designation of the inventor has not yet been filed
(74) Representative: Mewburn Ellis LLP

(57) **Abstract**

Various embodiments provide a charging device for charging a smoking substitute system, the charging device comprising: a housing having a holder for receiving a smoking substitute system; a first battery for charging a second battery in the smoking substitute system; charging circuitry having a connection interface disposed in the holder and arranged for connection to the smoking substitute system when the smoking substitute system is received in the holder, the charging circuitry operable to control charging of the second battery from the first battery; the housing having a first air inlet, a first air outlet in fluid communication with the holder and a first airflow path between the first air inlet and the first air outlet, wherein the first airflow path allows a flow of air from outside the housing into the holder, wherein the first airflow path is arranged to direct the flow of air via the charging circuitry. Some other embodiments provide a smoking substitute kit comprising: a charging device and a smoking substitute system comprising a second battery arranged to power the smoking substitute system.

## Description

### Field of the Invention

The present invention relates to a charging device for a smoking substitute system and a kit including both the charging device and the smoking substitute system.

### Background

The smoking of tobacco is generally considered to expose a smoker to potentially harmful substances. It is generally thought that a significant amount of the potentially harmful substances are generated through the heat caused by the burning and/or combustion of the tobacco and the constituents of the burnt tobacco in the tobacco smoke itself.

Combustion of organic material such as tobacco is known to produce tar and other potentially harmful byproducts. There have been proposed various smoking substitute systems in order to avoid the smoking of tobacco.

Such smoking substitute systems can form part of nicotine replacement therapies aimed at people who wish to stop smoking and overcome a dependence on nicotine.

Smoking substitute systems include electronic systems that permit a user to simulate the act of smoking by producing an aerosol (also referred to as a "vapour") that is drawn into the lungs through the mouth (inhaled) and then exhaled. The inhaled aerosol typically bears nicotine and/or a flavourant without, or with fewer of, the odour and health risks associated with traditional smoking.

In general, smoking substitute systems are intended to provide a substitute for the rituals of smoking, whilst providing the user with a similar experience and satisfaction to those experienced with traditional smoking and with combustible tobacco products.

The popularity and use of smoking substitute systems has grown rapidly in the past few years. Although originally marketed as an aid to assist habitual smokers wishing to quit tobacco smoking, consumers are increasingly viewing smoking substitute systems as desirable lifestyle accessories. There are a number of different categories of smoking substitute systems, each utilising a different smoking substitute approach.

One approach is the so-called "vaping" approach, in which a vaporisable liquid, typically referred to (and referred to herein) as "e-liquid", is heated by a heating device (referred to herein as an electronic cigarette or "e-cigarette" device) to produce an aerosol vapour which is inhaled by a user. The e-liquid typically includes a base liquid as well as nicotine and/or a flavourant. The resulting vapour therefore also typically contains nicotine and/or a flavourant. The base liquid may include propylene glycol and/or vegetable glycerine.

A typical e-cigarette device includes a mouthpiece, a power source (typically a battery), a tank for containing e-liquid, as well as a heating device. In use, electrical energy is supplied from the power source to the heating device, which heats the e-liquid to produce an aerosol (or "vapour") which is inhaled by a user through the mouthpiece.

E-cigarettes can be configured in a variety of ways. For example, there are "closed system" vaping smoking substitute systems, which typically have a sealed tank and heating element. The tank is prefilled with e-liquid and is not intended to be refilled by an end user. One subset of closed system vaping smoking substitute systems include a main body which includes the power source, wherein the main body is configured to be physically and electrically coupled to a consumable including the tank and the heating element. In this way, when the tank of a consumable has been emptied, that consumable is disposed of. The main body can be reused by connecting it to a new, replacement, consumable. Another subset of closed system vaping smoking substitute systems are completely disposable, and intended for one-use only.

There are also "open system" vaping smoking substitute systems which typically have a tank that is configured to be refilled by a user. In this way the entire device can be used multiple times.

An example vaping smoking substitute system is the myblu™ e-cigarette. The myblu™ e-cigarette is a closed system which includes a main body and a consumable. The main body and consumable are physically and electrically coupled together by pushing the consumable into the main body. The main body includes a rechargeable battery. The consumable includes a mouthpiece, a sealed tank which contains e-liquid, as well as a heater, which for this device is a heating filament coiled around a portion of a wick. The wick is partially immersed in the e-liquid, and conveys e-liquid from the tank to the heating filament. The device is activated when a microprocessor on board the main body detects a user inhaling through the mouthpiece. When the device is activated, electrical energy is supplied from the power source to the heating device, which heats e-liquid from the tank to produce a vapour which is inhaled by a user through the mouthpiece.

Where a smoking substitute system includes a rechargeable power source, such systems can be used in combination with a charging cable or charging device. The charging cable or charging device are connectable to the smoking substitute system to facilitate recharging of the rechargeable power source.

There is a continuing need to improve the manner in which smoking substitute systems with rechargeable power sources are charged, and the devices used for such charging.

The present invention has been devised in light of the above considerations.

### Summary of the Invention

At its most general, the present invention relates to a charging device for charging a smoking substitute system. The charging device comprises charging circuitry. The charging device is provided with an airflow path which allows a flow of air from outside a housing of the charging device to flow via the charging circuitry.

In this manner, air via the airflow path can provide a cooling effect to the charging circuitry. This can help to allow charging circuitry to operate at a desirable operating temperature, and may prevent overheating. It may allow the charging circuitry to safely operate for a longer period.

In some embodiments, air via the airflow path may also be used by the smoking substitute system for vapour generation.

According to a first aspect of the present invention, there is provided a charging device for charging a smoking substitute system, the charging device comprising: a housing having a holder for receiving a smoking substitute system; a first battery for charging a second battery in the smoking substitute system; charging circuitry having a connection interface disposed in the holder and arranged for connection to the smoking substitute system when the smoking substitute system is received in the holder, the charging circuitry operable to control charging of the second battery from the first battery; the housing having a first air inlet, a first air outlet in fluid communication with the holder and a first airflow path between the first air inlet and the first air outlet, wherein the first airflow path allows a flow of air from outside the housing into the holder, wherein the first airflow path is arranged to direct the flow of air via the charging circuitry.

Optionally, the first air inlet is on an outer surface of the housing, wherein the charging circuitry comprises an external connection interface disposed in an outer surface of the housing and arranged for connection to an external power source, the charging circuitry being operable to control charging of the first battery from the external power source, and wherein the first air inlet is proximal to, or part of, the external connection interface.

Optionally, at least part of the first airflow path is defined by an airflow conduit, and at least part of the charging circuitry is housed within the airflow conduit. The airflow conduit, duct, or other air-carrying structure, may extend between the first air inlet and the first air outlet. Alternatively, the airflow conduit may extend for part of the airflow path. The airflow conduit may enclose all of the charging circuitry, or part of the charging circuitry. For example, the charging circuitry may comprise at least one power electronics device, such as a power transistor, an integrated circuit providing a power conversion function, a DC-DC converter, or some other device that generates heat during operation.

Optionally, the airflow path is not defined by an airflow conduit. One or more airflow guiding structures may be provided. These are arranged to direct airflow over the charging circuitry.

Optionally, the holder has an aperture for receiving the smoking substitute system at a first end of the housing and wherein the first air inlet is provided on an outer surface of the housing at a second end of the housing, wherein the second end is opposite to the first end. In this manner, air enters the housing at a position which is typically free of obstructions, as a user typically grasps the housing on side faces.

Optionally, the first air outlet is provided at a base of the holder. This provides a long path over, or around, a body of the smoking substitute system, which improves a cooling effect, for example, by cooling the smoking substitute system.

Optionally, the holder comprises at least one sidewall, and wherein the first air outlet is provided along the side wall of the holder, at a position offset from a base of the holder. This can help to direct air to where it is most required. For example, the first air outlet may be disposed in a sidewall of the holder at a position which is proximal to a position of a system air inlet of the smoking substitute system when the smoking substitute system is received in the holder. This can improve airflow to the system air inlet.

Optionally, the housing comprises a second air inlet on an outer surface of the housing, a second air outlet in fluid communication with the holder and a second airflow path arranged to allow a flow of air from outside the housing into the holder, wherein the second airflow path comprises a conduit which passes directly between the second air inlet and the second air outlet. In this manner, airflow is improved to the holder and the smoking substitute system within the holder.

Optionally, the first airflow path allows a flow of air from outside the housing into the holder for use by the smoking substitute device in vapour generation. The airflow reaching the smoking substitute system provides a cooling effect to the charging circuitry in addition to being used for vapour generation. The airflow entering the smoking substitute system is effectively pre-heated by the charging circuitry, and may also be pre-heated by the body of the smoking substitute system. This can reduce the amount of heating required for vapour generation.

Optionally, the charging device is a portable charging case.

According to another aspect of the present invention, there is provided a smoking substitute kit comprising: a charging device according to the first aspect; and a smoking substitute system comprising a second battery arranged to power the smoking substitute system.

Optionally, the smoking substitute system is longer than the holder such that, when the smoking substitute system is inserted into the holder, a portion of the smoking substitute system protrudes from the charging device, and wherein the smoking substitute system is operable for vapour generation when the smoking substitute system is inserted into the holder. This allows the smoking substitute system to be used for vapour generation while it is being charged.

Optionally, the smoking substitute system has a system air inlet which is positioned within the holder when the smoking substitute system is inserted into the holder, and wherein the first airflow path allows a flow of air from outside the housing into the holder for vapour generation.

Optionally, the first air outlet is disposed in a sidewall of the holder at a position which is proximal to a position of the system air inlet of the smoking substitute system when the smoking substitute system is received in the holder.

The charging device may include a housing having a holder for receiving a main body of the smoking substitute system. The control circuitry may include a connection interface (e.g. an electrical connector) disposed in the holder and arranged for connection to the main body when the main body is received in the holder. In this manner, when the main body of the smoking substitute system is received in the holder, it may be connected to the control circuitry via the connection interface, so that the second battery may be recharged by the control circuitry and the second battery.

The connection interface may be arranged to connect to a corresponding connector on the main body of the smoking substitute system, to form an electrical connection between the control circuitry and the main body. For example, the connection interface may include a plug that is arranged to engage a corresponding socket on the main body (or vice versa) when the main body is received in the holder. The connection interface is disposed in the holder. In this manner, when the main body is inserted into the holder, the connection interface may engage the connector on the main body to form an electrical connection. Providing the connection interface in the holder may further serve to protect the connection interface, and avoid its coming into contact with a user.

The connection interface may be a universal serial bus (USB) interface (e.g. USB-C). In this manner, a main body having a USB connector may be charged by the charging device. A USB-C interface does not have different "up" and "down" orientations (i.e. it is a symmetrical connector), which may facilitate connecting the main body to the connection interface, as a user may connect the main body to the USB-C interface in either of the two possible orientations. In some other embodiments, however, an asymmetrical connector may be used instead, for example, a micro-USB connector. In this case, an outer surface of the housing may include a visual indicator signifying an orientation of the smoking substitute system necessary for the asymmetric electrical connector to engage with the smoking substitute system when the smoking substitute system is received in the holder. Conveniently, the visual indicator is a marking signifying a required location of a front or a back of the smoking substitute system as the smoking substitute system is inserted into the holder.

The holder may be formed as a cavity or recess in the housing and have a shape that is complementary to a shape of the main body of the smoking substitute system. A shape of the cavity may for example substantially match a cross-sectional shape of the main body of the smoking substitute system. For example, the cavity may be arranged to form an interference fit with the main body. Alternatively, the holder may have a cross-sectional area which is larger than the main body so that there is space to allow airflow to pass between the holder and the main body. This may ensure that the main body is securely held in the cavity. This may also ensure that only devices that are intended for use with the charging device may be inserted into the cavity, to prevent misuse of the charging device. This may also serve to avoid a user putting their finger into the cavity, where it may come into contact with the connection interface. In an embodiment, the connection interface may be positioned in a base of the cavity. In an embodiment, the cavity may be integrally formed as part of the housing, which may facilitate construction of the housing. For example, the housing may be formed as a single piece of moulded or 3D-printed plastic.

The charging device may include a cable for connecting the control circuitry to an external power source (e.g. a laptop, or a mains supply), wherein the control circuity is operable to control charging of the first battery from the external power source when the control circuitry is connected to the external power source. In this manner, the cable can be used to charge the first battery, for example, once it has become empty due to charging the smoking substitute system. Also, the charging device can be used to charge the smoking substitute system on-the-move, i.e. without needing to be attached to an external power source. In some cases, the cable may be removably connectable from the control circuitry, so that it may be disconnected from the charging device when not in use. For example, the charging device may include a plug or socket for connecting the cable. The cable may be a USB cable, and the charging device may include a USB connector (e.g. a USB female socket or a USB male plug) which is electrically coupled to the control circuitry and the first battery.

The charging device may further include a charge indicator for indicating a charging status of a main body received in the holder. In this manner, a user may be informed of the charging status of the main body. Herein, a charging status may be an indication that a main body received in the holder is being charged, or that it is fully charged. For example, the charge indicator may be an indicator light which is arranged to indicate the charging status. The indicator light may indicate via a blinking pattern of the indicator light (e.g. blinking means charging, no blinking means charged), or via a colour of the indicator light (e.g. red means charging, blue means charged). Other types of charge indicator are also contemplated, such as a display or the like. The charge indicator, or a second charge indicator of the charging device, may indicate a charging status of the charging device when it is connected to an external power source.

The charging device may be a charge case in which the holder is a cavity which is sized so as to receive a majority or an entirety of the main body of the smoking substitute system. For example, the cavity has a depth between 80mm and 100mm, and preferably between 85mm and 95mm, and more preferably between 87mm and 93mm, and still more preferably between 89mm and 91mm. Conveniently, the cavity has a depth of about 90mm.

The charging device may be a charge dock in which the holder is a cavity which is sized so as to receive only a minority or an end portion of the main body of the smoking substitute system. The housing of the charging device may be a base arranged to support the charging device on a surface. In this manner, the base may serve to maintain the charging device in an upright position when it is placed on a flat surface. The base may serve to ensure that the charging device is stable, and prevent it from being knocked over. For example, the base may include a support including a set of feet and/or a support surface arranged to support the charging device on a surface. The base may include one or more anti-slip elements (e.g. anti-slip pads), to prevent the base from slipping when it is placed on a surface. This may prevent the base from moving or slipping when an end portion of a main body of a smoking substitute system is inserted to and/or removed from the charging device.

It is to be understood that the smoking substitute system may be used (e.g. to generate vapour for inhalation) whilst it is connected to and being charged by the charging device.

The smoking substitute system may include a main body and a consumable, the consumable being engageable with the main body. The main body may have an engagement end which is engageable with the consumable, the engagement end being on an opposite end of the main body relative to an end portion which includes a connector that is arranged to engage the connection interface of the charging device when the main body is received in a holder of the charging device.

The holder of the charging device may have a shape that is complementary to a shape of the main body. The holder may have a cross-sectional area which is larger than the main body so that there is space to allow airflow to pass between the holder and the main body.

The connection interface may be arranged to engage a connector on the end portion of the main body when the end portion is received in the holder. As an example, where the connection interface is a USB interface, the end portion of the main body may include a USB connector arranged to engage the USB interface in the charging device when the end portion is received in the holder.

The consumable is configured for engagement with the main body (e.g. so as to form a closed smoking substitute system). The consumable may also be referred to as a "cartridge" or "pod" for the smoking substitute system. For example, the consumable may comprise components of the system that are disposable, and the main body may comprise non-disposable or non-consumable components (e.g. power supply, controller, sensor, etc.) that facilitate the delivery of aerosol by the consumable. In such an embodiment, an aerosol former (e.g. e-liquid) may be replenished by replacing a used consumable with an unused consumable.

Alternatively, the consumable may be reusable. In such embodiments an aerosol former (e.g. e-liquid) of the consumable may be replenished by re-filling e.g. a reservoir of the consumable with the aerosol former (rather than replacing a consumable component of the apparatus).

In light of this, it should be appreciated that some of the features described herein as being part of the consumable may alternatively form part of a main body.

The main body and the consumable may be configured to be physically coupled together. For example, the consumable may be at least partially received in a recess of the main body, such that there is an interference fit between the main body and the consumable. Alternatively, the main body and the consumable may be physically coupled together by screwing one onto the other, or through a bayonet fitti ng .

Thus, the consumable and main body may comprise one or more engagement portions for engagement with one another. In this way, one end of the consumable may be coupled with the main body, whilst an opposing end of the consumable may define a mouthpiece of the smoking substitute system.

The smoking consumable may comprise a reservoir configured to store an aerosol former, such as an e-liquid. The e-liquid may, for example, comprise a base liquid and e.g. nicotine. The base liquid may include propylene glycol and/or vegetable glycerine. The e-liquid may also contain a flavourant, to provide a flavour to the user.

The reservoir may be in the form of a tank. At least a portion of the tank may be translucent. For example, the tank may comprise a window to allow a user to visually assess the quantity of e-liquid in the tank. A housing of the main body may comprise a corresponding aperture (or slot) or window that may be aligned with a translucent portion (e.g. window) of the tank. The reservoir may be referred to as a "clearomizer" if it includes a window, or a "cartomizer" if it does not.

The consumable may comprise a passage for fluid flow therethrough. The passage may extend through (at least a portion of) the consumable, between openings that may define an inlet and an outlet of the passage. The outlet may be at a mouthpiece of the consumable. In this respect, a user may draw fluid (e.g. air) into and through the passage by inhaling at the outlet (i.e. using the mouthpiece). The passage may be at least partially defined by the tank. The tank may substantially (or fully) define the passage. In this respect, the tank may surround the passage.

The consumable may comprise an aerosol-generator. The aerosol generator may comprise a wick. The aerosol generator may further comprise a heater. The wick may comprise a porous material. A portion of the wick may be exposed to fluid flow in the passage. The wick may also comprise one or more portions in contact with liquid stored in the reservoir. For example, opposing ends of the wick may protrude into the reservoir and a central portion (between the ends) may extend across the passage so as to be exposed to fluid flow in the passage. Thus, fluid may be drawn (e.g. by capillary action) along the wick, from the reservoir to the exposed portion of the wick.

The heater may comprise a heating element, which may be in the form of a filament wound about the wick (e.g. the filament may extend helically about the wick). The filament may be wound about the exposed portion of the wick. The heating element may be electrically connected (or connectable) to a power source (e.g. a battery). Thus, in operation, the power source may supply electricity to (i.e. apply a voltage across) the heating element so as to heat the heating element. This may cause liquid stored in the wick (i.e. drawn from the tank) to be heated so as to form a vapour and become entrained in fluid flowing through the passage. This vapour may subsequently cool to form an aerosol in the passage.

The main body may comprise the second battery (e.g. a rechargeable battery). The second battery is arranged to power the smoking substitute system, for example, so that the smoking substitute system can generate vapour for inhalation by a user. The second battery may be electrically connected (or connectable) to a heater of the smoking substitute system (e.g. when engaged with the main body). A connector (e.g. in the form of a USB connector) may be provided on the end portion of the main body for recharging this battery via engagement with the connection interface in the holder of the charging device.

The consumable may comprise an electrical interface for interfacing with a corresponding electrical interface of the main body. One or both of the electrical interfaces may include one or more electrical contacts. Thus, when the main body is engaged with the consumable, the electrical interface may be configured to transfer electrical power from the power source to a heater of the consumable.

The electrical interface may also be used to identify the consumable from a list of known types. For example, the consumable may have a certain concentration of nicotine and the electrical interface may be used to identify this. The electrical interface may additionally or alternatively be used to identify when a consumable is connected to the main body.

The main body may comprise an interface, which may, for example, be in the form of an RFID reader, a barcode or QR code reader. This interface may be able to identify a characteristic (e.g. a type) of a consumable engaged with the main body. In this respect, the consumable may include any one or more of an RFID chip, a barcode or QR code, or memory within which is an identifier and which can be interrogated via the interface.

The main body may comprise a controller, which may include a microprocessor. The controller may be configured to control the supply of power from the power source to the heater of the smoking substitute apparatus (e.g. via the electrical contacts). A memory may be provided and may be operatively connected to the controller. The memory may include non-volatile memory. The memory may include instructions which, when implemented, cause the controller to perform certain tasks or steps of a method.

The main body may comprise a wireless interface, which may be configured to communicate wirelessly with another device, for example a mobile device, e.g. via Bluetooth®. To this end, the wireless interface could include a Bluetooth® antenna. Other wireless communication interfaces, e.g. WiFi®, are also possible. The wireless interface may also be configured to communicate wirelessly with a remote server.

A puff sensor may be provided that is configured to detect a puff (i.e. inhalation from a user). The puff sensor may be operatively connected to the controller so as to be able to provide a signal to the controller that is indicative of a puff state (i.e. puffing or not puffing). The puff sensor may, for example, be in the form of a pressure sensor or an acoustic sensor. That is, the controller may control power supplied to the heater of the consumable in response to a puff detection by the sensor. The control may be in the form of activation of the heater in response to a detected puff. That is, the smoking substitute system may be configured to be activated when a puff is detected by the puff sensor. The puff sensor may form part of the consumable or the main body.

The invention includes the combination of the aspects and preferred features described except where such a combination is clearly impermissible or expressly avoided.

### Summary of the Figures

So that the invention may be understood, and so that further aspects and features thereof may be appreciated, embodiments illustrating the principles of the invention will now be discussed in further detail with reference to the accompanying figures, in which:
Figure 1 is an isometric view of a smoking substitute kit, in accordance with an embodiment of the invention;
Figure 2A is a schematic side view of a smoking substitute system that may be used with a charging device according to an embodiment of the invention, where the smoking substitute system is in an engaged position;
Figure 2B is a schematic side view of the smoking substitute system of Figure 2A, where the smoking substitute system is in a disengaged position;
Figure 2C is a schematic end view of the smoking substitute system of Figure 2A;
Figure 2D is a cross-sectional diagram of a consumable of the smoking substitute system of Figure 2A;
Figure 3 is an isometric view of a charging device, in accordance with an embodiment of the invention;
Figure 4 is an isometric view of the charging device of Figure 3, showing a different inlet to the smoking substitute system;
Figure 5 is an isometric view of a charging device, in accordance with another embodiment of the invention; and
Figure 6 is an isometric view of a charging device, in accordance with another embodiment of the invention.

### Detailed Description of the Invention

Aspects and embodiments of the present invention will now be discussed with reference to the accompanying figures. Further aspects and embodiments will be apparent to those skilled in the art. All documents mentioned in this text are incorporated herein by reference.

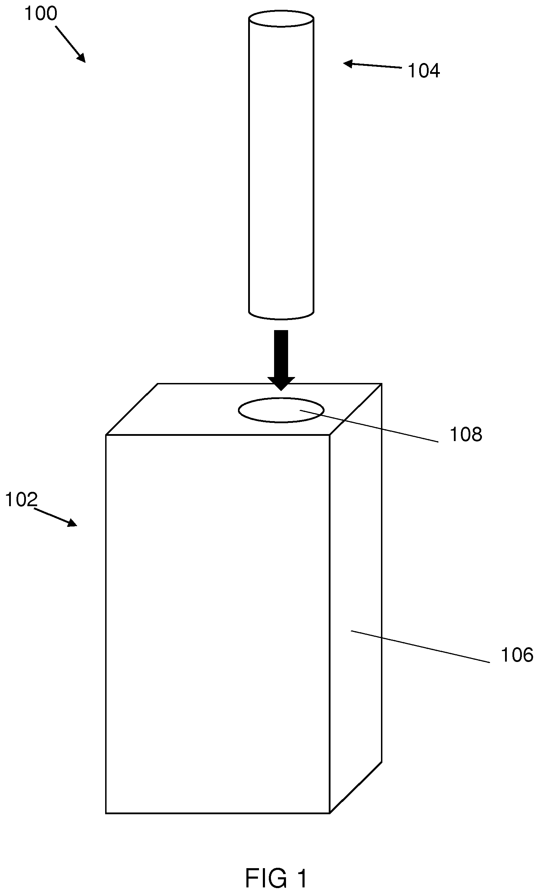

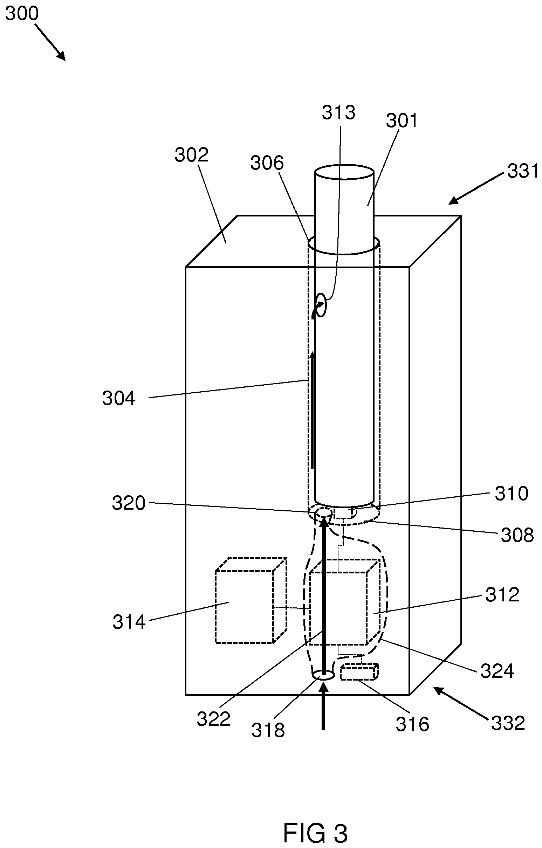

Figure 1 shows a smoking substitute kit 100 including a charging device 102 and a smoking substitute system 104. In the embodiment of Figure 1, the charging device 102 takes the form of a charge case. The charging device 102 has a first battery (not shown) which is operable to charge a second battery (not shown) of the smoking substitute system 104 when the charging device 102 is connected to the smoking substitute system 104. A charging device similar to device 102 is described in more detail below in relation to Figure 3.

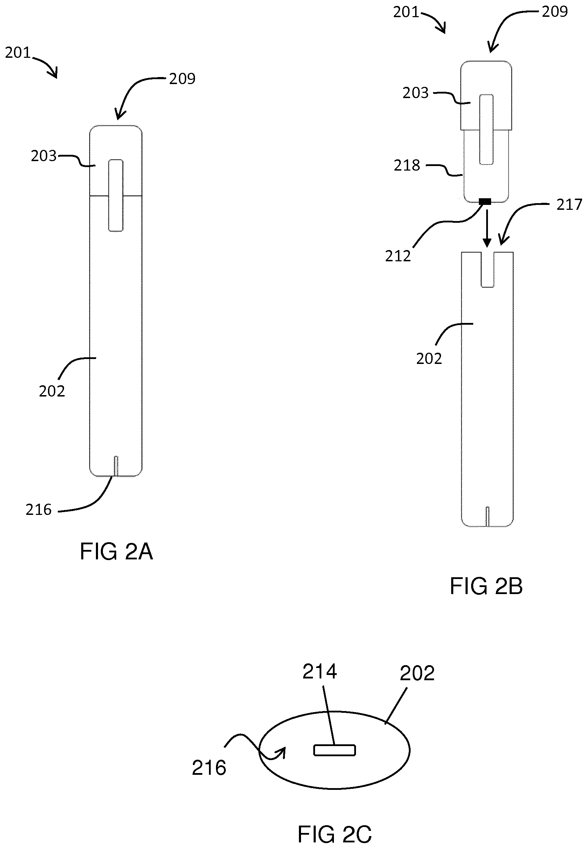

The smoking substitute system 104 has a second battery (not shown) which is operable to power the smoking substitute system, for example, to heat an e-liquid to generate vapour for inhalation by a user. A smoking substitute system similar to system 104 is described in more detail below in relation to Figures 2A-2D.

The charging device 102 may include a housing 106 having a holder 108 (e.g. a cavity or recess) for receiving a portion of the smoking substitute system 104. Also, the charging device 102 includes charging or control circuitry (not shown) which is operable to control charging of the second battery, for example, in accordance with a constant-current-constant-voltage (CCCV) charging scheme.

In an embodiment, the control circuitry includes a connection interface (e.g. a USB connector) disposed in the holder 108 and arranged (e.g. positioned or located) for connection to the smoking substitute system 104 when the smoking substitute system 104 is received in the holder 108. For example, the connection interface may include a plug positioned in a base of the holder 108, and a cooperating socket may be positioned in an end face of the smoking substitute system 104, such that when the smoking substitute system 104 is fully inserted into the holder 108, the plug engages with the socket so as to form an electrical connection between, on the one hand, the control circuity and the first battery and, on the other hand, the second battery. In this way, the second battery may be charged from the first battery, as described above.

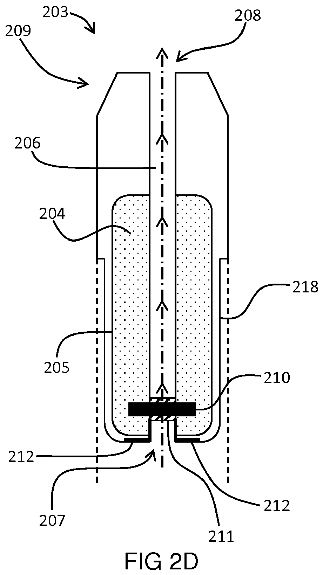

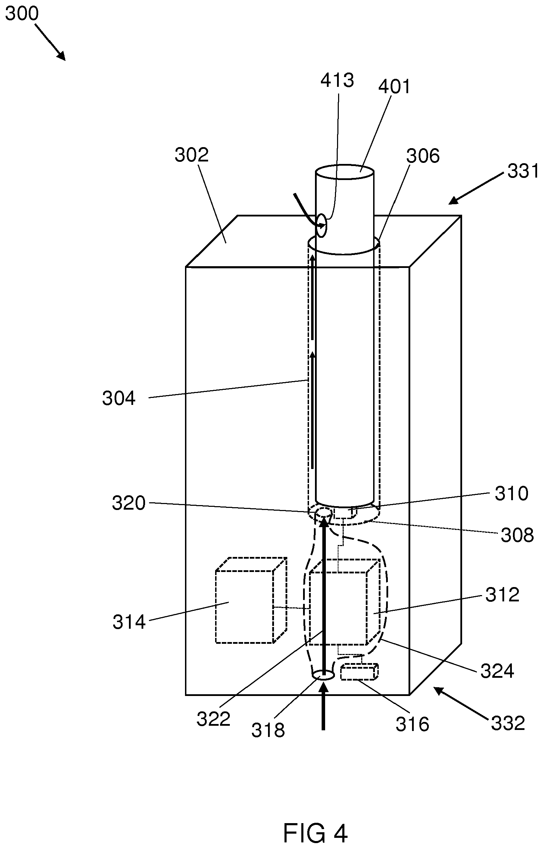

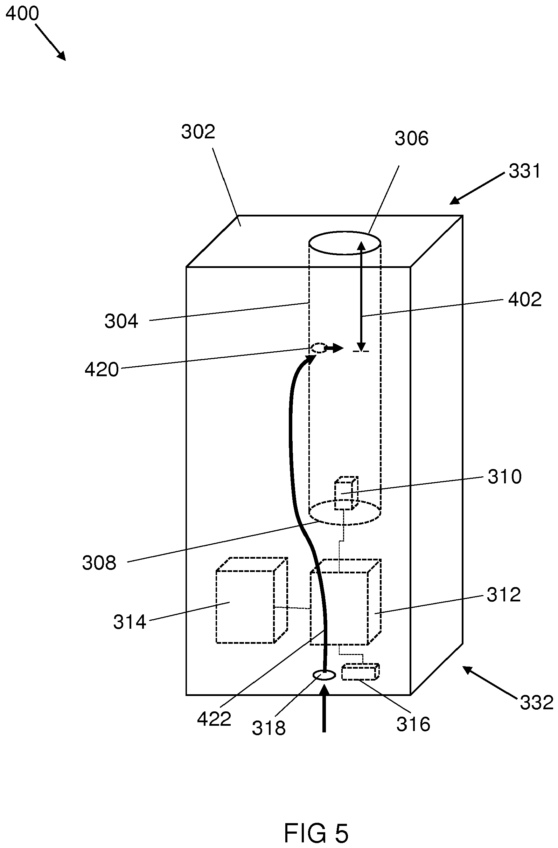

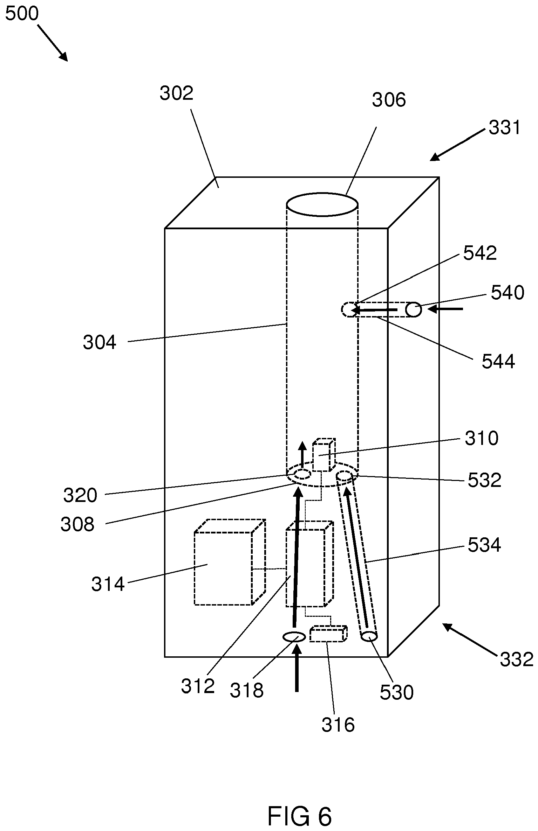

Figures 2A, 2B and 2C illustrate a smoking substitute system in the form of an e-cigarette system 201. The system may, for example, be used with charging device 102 of Figure 1 described above or with the charging device 300 of Figures 3 and 4, the charging device 400 of Figure 5, or the charging device 500 of Figure 6 described below. The system 201 comprises an e-cigarette device defining a main body 202 of the system 201, and an e-cigarette consumable (or "pod") 203. In the illustrated embodiment the consumable 203 is removable from the main body (e-cigarette device), so as to be a replaceable component of the system 201. In other words, the e-cigarette system 201 is a closed system. A cross-sectional view of the consumable 203 is shown in Figure 2D.

As is apparent from Figures 2A and 2B, the consumable 203 is configured to engage the main body 202. The main body 202 includes an engagement portion 217, which is in the form of a cavity disposed at a first end of the main body 202. The engagement portion 217 of the main body 202 is arranged to engage an engagement portion 218 on the consumable 203. Figure 2A shows the main body 202 and the consumable 203 in an engaged state, whilst Figure 2B shows the main body 202 and the consumable 203 in a disengaged state. When engaged, the engagement portion 218 of the consumable 203 is received in the cavity of the engagement portion 217 of the main body 202, and is retained in the engaged position by way of a snap-engagement mechanism. In other embodiments, the main body 202 and consumable 203 may be engaged by screwing one into (or onto) the other, through a bayonet fitting, or by way of an interference fit.

The system 201 is configured to vaporise an aerosol-former, which in the illustrated embodiment, is in the form of a nicotine-based e-liquid 204. The e-liquid 204 comprises nicotine and a base liquid including propylene glycol and/or vegetable glycerine. The e-liquid 204 may also comprise a flavourant, for producing a flavoured aerosol.

As is more apparent from Figure 2D, the e-liquid 204 is stored within a reservoir in the form of a tank 205 that forms part of the consumable 203. In the illustrated embodiment, the consumable 203 is a "single-use" consumable 203. That is, upon exhausting the e-liquid 204 in the tank 205, the intention is that the user disposes of the entire consumable 203. In other embodiments, the e-liquid (i.e. aerosol former) may be the only part of the system that is truly "single-use". That is, the tank may be refillable with e-liquid or the e-liquid may be stored in a non-consumable component of the system. For example, the e-liquid may be stored in a tank located in the main body or stored in another component that is itself not single-use (e.g. a refillable cartomizer).

The tank 205 surrounds, and thus defines a portion of, a passage 206 that extends between an inlet 207 and an outlet 208 at opposing ends of the consumable 203. In this respect, the passage comprises an upstream end at the end of the consumable 203 that engages with the main body 202, and a downstream end at an opposing end of the consumable 203 that comprises a mouthpiece 209 of the system 201. When the consumable 203 is engaged with the main body 202, a user can inhale (i.e. take a puff) via the mouthpiece 209 so as to draw air through the passage 206, and so as to form an airflow (indicated by arrows) in a direction from the inlet 207 to the outlet 208 of the passage 206. Although not illustrated, the passage 206 may be partially defined by a tube (e.g. a metal tube) extending through the consumable 203. The passage 206 is in fluid communication with a gap defined between the consumable 203 and the main body 202 (when engaged) such that air outside of the system 201 is drawn into the passage 206 (during an inhale).

The smoking substitute system 201 is configured to vaporise the e-liquid 204 for inhalation by a user. To provide this, the consumable 203 comprises a heater having of a porous wick 210 and a resistive heating element in the form of a heating filament 211 that is helically wound around a portion of the porous wick 210. The porous wick 210 extends across the passage 206 (i.e. transverse to a longitudinal axis of the passage 206) and opposing ends of the wick 210 extend into the tank 205 (so as to be submerged in the e-liquid 204). In this way, e-liquid 204 contained in the tank 205 is conveyed from the opposing ends of the porous wick 210 to a central portion of the porous wick 210 so as to be exposed to the airflow in the passage 206 (i.e. caused by a user inhaling).

The helical filament 211 is wound about this exposed central portion of the porous wick 210 and is electrically connected to an electrical interface in the form of electrical contacts 212 mounted at the end of the consumable that is proximate the main body 202 (when engaged). When the consumable 203 is engaged with the main body 202, the electrical contacts 212 contact corresponding electrical contacts (not shown) of the main body 202. The main body electrical contacts are electrically connected to a power source (not shown) of the main body 202, such that (in the engaged position) the filament 211 is electrically connected to the power source. In this way, power can be supplied by the main body 202 to the filament 211 in order to heat the filament 211. This heat is transferred from the filament 211 to the porous wick 210 which causes e-liquid 204 conveyed by the porous wick 210 to increase in temperature to a point at which it vaporises. The vaporised e-liquid becomes entrained in the airflow and, between the vaporisation point at the filament 211 and the outlet 208 of the passage 206, condenses to form an aerosol. This aerosol is then inhaled, via the mouthpiece 209, by a user of the system 201.

The power source of the main body 202 may be in the form of a battery (i.e. the second battery; e.g. a rechargeable battery). As is more apparent from Figure 2C, the main body 202 includes a connector 214 in the form of e.g. a USB or USB-C port for recharging the battery. The connector 214 is disposed on an end face 216 of the main body 202, which is at second end of the main body 202, opposite the first end comprising the engagement portion 217. The connector 214 is arranged to engage a corresponding connection interface in a charging device to recharge the battery.

The main body 202 may also comprise a controller that controls the supply of power from the power source to the main body electrical contacts (and thus to the filament 211). That, is the controller may be configured to control a voltage applied across the main body electrical contacts, and thus the voltage applied across the filament 211. In this way, the filament 211 may only be heated under certain conditions (e.g. during a puff and/or only when the system is in an active state). In this respect, the main body 202 may include a puff sensor (not shown) that is configured to detect a puff (i.e. inhalation). The puff sensor may be operatively connected to the controller so as to be able to provide a signal, to the controller, which is indicative of a puff state (i.e. puffing or not puffing). The puff sensor may, for example, be in the form of a pressure sensor or an acoustic sensor.

Although not shown, the main body 202 and consumable 203 may comprise a further interface which may, for example, be in the form of an RFID reader, a barcode or QR code reader. This interface may be able to identify a characteristic (e.g. a type) of a consumable 203 engaged with the main body 202. In this respect, the consumable 203 may include any one or more of an RFID chip, a barcode or QR code, or memory within which is an identifier and which can be interrogated via the interface.

The main body 202 is shaped so that it is receivable in a holder of a charging device (e.g. holder 108 of charging device 102). In particular, a cross-sectional shape of the main body 202 may correspond to a shape of the holder. The holder may have a cross-sectional area which is larger than the main body 202 so that there is space to allow airflow to pass between the holder and the main body 202. Moreover, the connector 214 on the end face 216 is arranged to engage a corresponding connection interface disposed in the holder when the main body 202 is received in the holder. In this manner, when the main body 202 is received in the holder of a charging device, the main body 202 may be connected to the charging device via the connector 214 on its end face 216, so that the battery in the main body 202 may be recharged.

Figure 3 shows a charging device 300 in accordance with an embodiment. The charging device 300 may be similar to the charging device 102 of Figure 1. The charging device 300 acts as a case to hold a smoking substitute system (e.g. the system 104 of Figure 1, or the system 201 of Figures 2A to 2D) and as a mechanism by which a battery of the smoking substitute system can be charged. To aid clear understanding of the following description, it will be assumed that the charging device 300 is used with the smoking substitute system 201 of Figures 2A to 2D. However, it is to be understood that in some other embodiments, the charging device 300 is used with a different smoking substitute system.

The charging device 300 includes a housing 302 having a holder in the form of a recess or cavity 304 for receiving the main body 202 of the smoking substitute system 201. Also, the cavity 304 includes a connection interface (or electrical connector) 310 positioned to engage with the connector 214 when the smoking substitute system 201 is received in the cavity 304 so as to permit charging of the smoking substitute system 201. Components of the charging device which are inside the housing 302 are shown in broken lines.

In an embodiment, the cavity 304 has a generally tubular cross-section and so defines a generally tubular void. Specifically, the cavity 304 includes a sidewall which terminates in an aperture 306 at one end (e.g. the top end, as shown in Fig. 3) and terminates in a base wall 308 at the other end (e.g. the bottom end, as shown in Fig. 3). Since the cavity 304 receives the smoking substitute system 201, a shape of the cross-section of the cavity 304 accommodates a shape of the cross-section of the smoking substitute system 201. For example, the cavity 304 of the charging device 300 and the main body 202 of the smoking substitute system 201 may both have a generally oval shaped cross-section, wherein the respective sizes of the two ovals are such that the main body 202 fits within the cavity 304. That is, the oval of the main body 202 may have the same shape but a slightly reduced area compared to the oval of the cavity 304. The oval shape may be truncated at each end along its maximum diameter. In an embodiment, the maximum and minimum widths of the oval shape of the main body 202 may be about 20mm and about 12mm, respectively, whereas the maximum and minimum widths of the oval shape of the cavity 304 may be about 22mm and about 14mm, respectively.

Additionally, in an embodiment, the cavity 304 has a depth which corresponds with a length of the main body 202 of the smoking substitute system 201. For instance, a depth of the cavity 304 may be approximately equal to a length of the main body 202. For example, if the maximum length of the main body 202 is about 90mm, the cavity 304 may have a maximum depth between 80mm and 100mm (e.g. main body length ±10mm), and preferably between 85mm and 95mm (e.g. main body length ±5mm), and more preferably between 87mm and 93mm (e.g. main body length ±3mm), and still more preferably between 89mm and 91mm (e.g. main body length ±1mm). Alternatively, the cavity 304 may have a maximum depth of about 90mm. In this way, when the smoking substitute system 201 is inserted into the cavity 304, the engagement portion 217 end of the main body 202 may be substantially flush with the cavity aperture 306, or the engagement portion 217 end of the main body 202 may extend outside the cavity aperture 306. As such, the consumable 203 may be inserted into the main body 202 when the main body 202 is received within the cavity 304 such that part of the consumable 203 is substantially proud of the charging device 300. The consumable 203 may have a total length of about 45mm but, when inserted into the main body 202, the consumable 203 may only protrude about 20mm beyond the main body 202. As such, when the smoking substitute system 201 is inserted into the cavity 304, the consumable 203 may protrude about 20mm beyond the charging device 300. In this way, the smoking substitute system 201 may be used to generate vapour whilst engaged with the charging device 300.

The connection interface 310 may be positioned in a base portion of the cavity 304, for example, on or proximal to the base wall 308. Specifically, the connection interface 310 may be fixed to the base wall 308 and may protrude at least partially into the cavity void. The connection interface 310 may be one part of a USB connection, for example, a USB-C plug or a micro USB plug. That is, the connection interface 310 may be one part of a two-part symmetrical connection (i.e. USB-C) or be one part of a two-part asymmetrical connection (i.e. micro-USB, Type-A, Type-B or Type-AB USB connectors).

It is to be understood that a two-part *asymmetric* electrical connection is considered to be a two-part electrical connection between first and second asymmetric electrical connectors. These first and second connectors are asymmetric in the sense that they can only be mechanically and electrically connected together (i.e. engaged) in only one way or orientation. For example, a specific part (e.g. a top) of the first connector must be aligned with a specific part (e.g. a top) of the second connector before the two connectors can be engaged together to form a mechanical and electrical connection. That is, the two connectors cannot be engaged together to form the mechanical and electrical connection if these two specific parts are not aligned.

On the other hand, a two-part *symmetric* electrical connector is considered to be a two-part electrical connection between first and second connectors that can be mechanically and electrically connected together (i.e. engaged) in either or any way or orientation. For example, a top or bottom of the first connector may be aligned with either a top or bottom of the second connector for the two connectors can be engaged together to form a mechanical and electrical connection.

As also seen in Figure 3, the charging device 300 includes a battery 314 (e.g. a rechargeable battery) which is electrically coupled to control circuitry 312. The connection interface 310 is electrically coupled to the control circuitry 312, for example, the connection interface 310 may be part of the control circuitry 312. The control circuitry may include a printed circuit board. As before, the battery 314 and the control circuitry 312 are shown with broken lines to illustrate that they are inside the housing 302.

In use, the main body 202 of the smoking substitute system 201 is pushed into the cavity 304, via the aperture 306, until the electrical connector 214 of the main body 202 engages with the connection interface 310 of the cavity 304 so as to form a mechanical and electrical connection there-between. The control circuitry 312 is operable to provide electrical power or energy (e.g. a voltage or current) from the battery 314 to the connection interface 310 when the connection interface 310 is engaged with electrical connector 214 so as to charge the battery (i.e. the second battery) in the main body 202.

In the above-described embodiments, the cavity 304 is positioned off-centre with respect to the housing 302 of the charging device 300. However, it is to be understood that in some other embodiments, the cavity 304 may be substantially central with respect to the housing 302.

In the above-described embodiments, the charging device 300 is shown and described as being substantially rectangular. However, it is to be understood that in some other embodiments, the shape of the charging device 300 may vary provided that it can still contain the above-described components and perform the above-described functions. For example, the charging case may be rectangular but have curved edges. Also, the charging case may have a substantially oval or truncated-oval cross-section.

The charging device 300 may include a cable (not shown) which serves to removably connect the charging device 300 to an external power source (not shown). When present, the cable is removably connected to the control circuitry 312, for example, via a connection port 316 (or external connection interface) which may be disposed on an outer surface of the housing 302 and electrically coupled to the control circuitry 312. The connection port 316 may form part of the control circuitry 312. For example, the connection port may be a USB connector, such as, a female USB socket. Accordingly, a first end of the cable may terminate in a cooperating connector, such as, a male USB plug. Further, a second send of the cable may terminate in a connector for connecting the cable to an external power source, e.g. to a computer or mains supply. That is, the second end may also terminate in a USB connector, such as, a male USB plug. Although in the present example the cable is presented as having a USB connector, other types of connectors may also be used, depending upon the type of power source used.

In this manner, the cable may be removably plugged into an external power source and the charging device 300 to provide power to the control circuitry 312 which can be used to charge the battery 314, for example, when the charge of battery 314 has been depleted from charging a smoking substitute system. In some other examples, the control circuitry 312 may include electrical components which are arranged to convert a voltage and/or current provided by the cable to a desired level, to ensure that a desired power level may be delivered to the battery 314.

The charging device 300 may also include a charge indicator (not shown) in the form of an indicator light on an outer surface of the housing 302. The indicator light serves to indicate a charging status of the smoking substitute system when it is plugged into the charging device 300, i.e. whether the smoking substitute system is charging or whether it is charged. The indicator light may be arranged to indicate the charging status in various manners, e.g. via a colour of the indicator light and/or via a blinking pattern of the indicator light. The indicator light may also indicate a charging status of the charging device battery.

Features relating to providing airflow to the holder 304 will now be described. The holder 304 has an aperture 306 for receiving the smoking substitute system 201 at a first end 331 of the housing 302. A first air inlet 318 is provided on an outer surface of the housing 302. The first air inlet 318 is provided on an outer surface of the housing at a second end 332 of the housing, opposite to the first end 331.

A first air outlet 320 is provided at the base 308 of the holder 304. The first air outlet 320 is in fluid communication with the holder 304. That is, air can flow from the first fluid outlet 320 into the cavity defined by the holder 304. An airflow path, or a passageway, (shown schematically by arrow 322) fluidly communicates between the first air inlet 318 and the first air outlet 320. All, or a portion of, the airflow path 322 may be defined by an airflow conduit. The airflow conduit may house, or enclose, all of the control/charging circuitry 312. Alternatively, the airflow conduit may house, or enclose, part of the control/charging circuitry 312. The control/charging circuitry 312 may comprise at least one power electronics device, such as a power transistor, an integrated circuit providing a power conversion function, a DC-DC converter, or some other device that generates heat during operation. The airflow conduit may house, or enclose, at least the power electronics device(s) of the charging circuitry 312. A conduit is schematically shown in dashed form 324. The conduit may have a varying cross-section between the first air inlet 318 and the first air outlet 320. The airflow conduit may help to direct the incoming airflow to places where it is needed, and may avoid airflow being lost in other parts of the charging device. In an embodiment, the airflow conduit may be formed from a separate element (e.g. a tubular structure) which is inserted inside the housing 302 and, possibly, is secured to the charging circuitry 312, the inlet 318, or the outlet 320. Additionally or alternatively, the airflow conduit may be formed from one or more internal walls of the housing 302 which protrude from an inner surface of the housing 302.

An alternative to a conduit is to provide one or more airflow-guiding structures, such as diverters, directors, or vanes, which function to direct airflow along a path where the airflow is required to provide a cooling effect. An airflow-guiding structure may direct air over the control/charging circuitry 312. The airflow path is a guided path through the housing 302. Similarly to the airflow conduits, these airflow-guiding structures may be formed from a separate structure secured within the housing 302 and/or an internal wall of the housing 302 which protrudes from an inner surface thereof.

In use, a smoking substitute system is inserted into the holder 304. An electrical connector (214, Figure 2C) of the main body 202 of the smoking substitute system engages with the connection interface 310 of the holder 304 so as to form an electrical connection (and, possibly, a mechanical connection) there-between. The smoking substitute system can begin to charge under the control of control/charging circuitry 312. A user can use the smoking substitute system while it is inserted into the holder 304.

Figure 3 and Figure 4 show two alternative types of smoking substitute system. The types of smoking substitute system differ in the position of the air inlet to the smoking substitute system. This will be called a "system air inlet" to avoid confusion with the air inlet of the charging device 300. In Figure 3 a smoking substitute system 301 has a system air inlet 313 which is positioned within the holder 304 when the smoking substitute system 301 is inserted into the holder 304. That is, the system air inlet 313 lies beneath the top aperture 306 of the charging device 300. When the smoking substitute system 301 is used for vapour generation, air is drawn into the system air inlet 313. This, in turn, causes air to be drawn from outside the housing 302 via the first air inlet 318. Air entering via air inlet 318 passes along airflow path 322 via the charging circuitry 312, through the first air outlet 320 and along a gap between the holder 304 and the smoking substitute system 301 until it reaches the system air inlet 313 of the smoking substitute system. The airflow path 322 provides a cooling effect to the control/charging circuitry 312. The airflow path 322 also provides a flow of air from outside the housing into the holder for vapour generation.

In Figure 4 a smoking substitute system 401 has a system air inlet 413 which is positioned outside the holder 304 when the smoking substitute system 401 is inserted into the holder 304. That is, the system air inlet 413 lies above (or substantially at the level of) the top aperture 306 of the charging device 300. When the smoking substitute system 401 is used for vapour generation, air is drawn into the system air inlet 413. Due to the position of the system air inlet, a majority of air reaching the system air inlet 413 will be obtained from the surrounding environment. When the smoking substitute system 401 is used for vapour generation, the body of the smoking substitute system 401 will become warm due to a heater within the smoking substitute system 401. This will heat air in the holder surrounding the smoking substitute system 401, and may also heat the holder 304. This will cause air in this region of the holder 304 to flow out of the aperture 306. It will also cause air to be drawn from outside the housing 302 via the air inlet 318, due to a chimney or stack effect. Air entering via first air inlet 318 passes along airflow path 322 via the charging circuitry 312, through the first air outlet 320 and along a gap between the holder 304 and the smoking substitute system 301 until it reaches the system air inlet 313 of the smoking substitute system. The airflow path 322 provides a cooling effect to the control/charging circuitry 312.

Although the first air inlet 318 is provided on a base of the housing 302, the first air inlet may be provided on another part of the housing 302, such as a front face, a rear face, a top face, or one of the side faces.

As mentioned above, the control/charging circuitry 312 comprises the external connection interface 316 disposed on an outer surface of the housing. The external connection interface 316 is arranged for connection (e.g. via a removable cable) to an external power source. The control/charging circuitry 312 is operable to control charging of the battery 314 from the external power source. The first air inlet 318 may be proximal to, or integral with, or part of, the external connection interface 316.

Figure 5 shows a charging device 400 in accordance with another embodiment. The charging device 400 is similar to the charging device 300 of Figures 3 and 4. In this embodiment, the air outlet 420 is disposed in a sidewall of the holder 304. An airflow path, or passageway, 422 fluidly communicates between the first air inlet 318 and the first air outlet 420. The airflow path is shown schematically. As described above for the airflow passageway 322 of Figure 3, at least a portion of the airflow passageway 422 may be in the form of an airflow conduit. The airflow conduit may enclose the control/charging circuitry 312, or at least a portion of the control/charging circuitry 312. This can prevent air flow from being lost within the housing. The charging device 400 of Figure 5 may be used with the smoking substitute system 301 shown in Figure 3 or with the smoking substitute system 401 shown in Figure 4. The first air outlet 420 may be disposed in a sidewall of the holder 304 at a position which is proximal to a position of the system air inlet 313 (Figure 3) of the smoking substitute system 301 when the smoking substitute system is received in the holder 304. Alternatively, the first air outlet 420 may be disposed in a sidewall of the holder 304 at a position which is proximal to, or below, a heat-generating component of the smoking substitute system 301, 401 when the smoking substitute system is received in the holder 304. For example, in the smoking substitute system 201 of Figures 2A-2D the heat-generating component is a heating filament 211.

Figure 6 shows a charging device 500 in accordance with another embodiment. The charging device 500 is similar to the charging device 300 of Figure 3. One or more further airflow paths are provided in the charging device 500. The further airflow path(s) provides a direct path for air. Air can pass directly between an outside of the housing 302 and the holder 304. The further airflow path(s) may not pass via control/charging circuitry, or any other components of the charging device.

A first example of a direct airflow path comprises conduit 534. Conduit 534 fluidly connects air inlet 530 on an outer surface of the housing 302 to an air outlet 532 at a base of the cavity of holder 304. Air inlet 530 is located at a second end 332 of the housing.

A second example of a direct airflow path comprises conduit 544. Conduit 544 fluidly connects air inlet 540 on an outer surface of the housing 302 to an air outlet 542. The air outlet 542 may be located proximate to, or near to, where the device air inlet is located when the smoking substitute system is inserted into the holder 304. Only one of the direct airflow paths may be provided.

The charging device 400 of Figure 6 may be used with the smoking substitute system 301 shown in Figure 3 or with the smoking substitute system 401 shown in Figure 4. The air outlet 542 may be disposed in a sidewall of the holder 304 at a position which is proximal to a position of the system air inlet 313 (Figure 3) of the smoking substitute system 301 when the smoking substitute system is received in the holder 304. Alternatively, the air outlet 542 may be disposed in a sidewall of the holder 304 at a position which is proximal to, or below, a heat-generating component of the smoking substitute system 301, 401 when the smoking substitute system is received in the holder 304. For example, in the smoking substitute system 201 of Figures 2A-2D the heat-generating component is a heating filament 211.

In the above-described embodiments, the charging device is presented in the form of a charge case. However, it is to be understood that in at least some other embodiments, the charging device may not be a charge case. For example, the charging device may be a charging station or charging dock. For example, the charging device may include a base which is arranged to rest on a surface (e.g. a desk or table). The base may include a set of anti-slip feet to prevent the base from slipping on the surface. The base may include a holder which is formed as a recess in an outer housing of the base. The outer housing of the base may be formed, for example, as a single component. In this manner, the recess forming the holder can be integrally formed as part of the outer housing. For example, the outer housing may be a plastic component made via a moulding or 3D-printing technique. The base may contain the control circuitry and first battery.

The features disclosed in the foregoing description, or in the following claims, or in the accompanying drawings, expressed in their specific forms or in terms of a means for performing the disclosed function, or a method or process for obtaining the disclosed results, as appropriate, may, separately, or in any combination of such features, be utilised for realising the invention in diverse forms thereof.

While the invention has been described in conjunction with the exemplary embodiments described above, many equivalent modifications and variations will be apparent to those skilled in the art when given this disclosure. Accordingly, the exemplary embodiments of the invention set forth above are considered to be illustrative and not limiting. Various changes to the described embodiments may be made without departing from the spirit and scope of the invention.

For the avoidance of any doubt, any theoretical explanations provided herein are provided for the purposes of improving the understanding of a reader. The inventors do not wish to be bound by any of these theoretical explanations.

Any section headings used herein are for organizational purposes only and are not to be construed as limiting the subject matter described.

Throughout this specification, including the claims which follow, unless the context requires otherwise, the words "have", "comprise", and "include", and variations such as "having", "comprises", "comprising", and "including" will be understood to imply the inclusion of a stated integer or step or group of integers or steps but not the exclusion of any other integer or step or group of integers or steps.

It must be noted that, as used in the specification and the appended claims, the singular forms "a," "an," and "the" include plural referents unless the context clearly dictates otherwise. Ranges may be expressed herein as from "about" one particular value, and/or to "about" another particular value. When such a range is expressed, another embodiment includes from the one particular value and/or to the other particular value. Similarly, when values are expressed as approximations, by the use of the antecedent "about," it will be understood that the particular value forms another embodiment. The term "about" in relation to a numerical value is optional and means, for example, +/- 10%.

The words "preferred" and "preferably" are used herein refer to embodiments of the invention that may provide certain benefits under some circumstances. It is to be appreciated, however, that other embodiments may also be preferred under the same or different circumstances. The recitation of one or more preferred embodiments therefore does not mean or imply that other embodiments are not useful, and is not intended to exclude other embodiments from the scope of the disclosure, or from the scope of the claims.

## Claims

1. A charging device for charging a smoking substitute system, the charging device comprising:
a housing having a holder for receiving a smoking substitute system;
a first battery for charging a second battery in the smoking substitute system;
charging circuitry having a connection interface disposed in the holder and arranged for connection to the smoking substitute system when the smoking substitute system is received in the holder, the charging circuitry operable to control charging of the second battery from the first battery;
the housing having a first air inlet, a first air outlet in fluid communication with the holder and a first airflow path between the first air inlet and the first air outlet, wherein the first airflow path allows a flow of air from outside the housing into the holder, wherein the first airflow path is arranged to direct the flow of air via the charging circuitry.

2. The charging device according to claim 1, wherein the first air inlet is on an outer surface of the housing, wherein the charging circuitry comprises an external connection interface disposed in an outer surface of the housing and arranged for connection to an external power source, the charging circuitry being operable to control charging of the first battery from the external power source, and wherein the first air inlet is proximal to, or part of, the external connection interface.

3. The charging device of any one of the preceding claims, wherein at least part of the first airflow path is defined by an airflow conduit, and at least part of the charging circuitry is housed within the airflow conduit.

4. The charging device of claim 3, wherein the charging circuitry comprises at least one power electronics device, and the at least one power electronics device is housed within the airflow conduit.

5. The charging device of any one of the preceding claims, wherein at least part of the airflow path is defined by an airflow guiding structure which is arranged to direct airflow over the charging circuitry.

6. The charging device of any one of the preceding claims, wherein the holder has an aperture for receiving the smoking substitute system at a first end of the housing and wherein the first air inlet is provided on an outer surface of the housing at a second end of the housing, wherein the second end is opposite to the first end.

7. The charging device of any one of the preceding claims, wherein the first air outlet is provided at a base of the holder.

8. The charging device of any one of claims 1 to 6, wherein the holder comprises at least one sidewall, and wherein the first air outlet is provided along the side wall of the holder, at a position offset from a base of the holder.

9. The charging device of any one of the preceding claims, wherein the housing comprises a second air inlet on an outer surface of the housing, a second air outlet in fluid communication with the holder and a second airflow path arranged to allow a flow of air from outside the housing into the holder, wherein the second airflow path comprises a conduit which passes directly between the second air inlet and the second air outlet.

10. The charging device of any one of the preceding claims, wherein the first airflow path allows a flow of air from outside the housing into the holder for use by the smoking substitute device in vapour generation.

11. The charging device of any one of the preceding claims, wherein the charging device is a portable charging case.

12. A smoking substitute kit comprising:
a charging device according to any one of the preceding claims; and
a smoking substitute system comprising a second battery arranged to power the smoking substitute system.

13. The smoking substitute kit of claim 12, wherein the smoking substitute system is longer than the holder such that, when the smoking substitute system is inserted into the holder, a portion of the smoking substitute system protrudes from the charging device, and wherein the smoking substitute system is operable for vapour generation when the smoking substitute system is inserted into the holder.

14. The smoking substitute kit of claim 12 or 13, wherein the smoking substitute system has a system air inlet which is positioned within the holder when the smoking substitute system is inserted into the holder, and wherein the first airflow path allows a flow of air from outside the housing into the holder for vapour generation.

15. The smoking substitute kit of claim 14, wherein the first air outlet is disposed in a sidewall of the holder at a position which is proximal to a position of the system air inlet of the smoking substitute system when the smoking substitute system is received in the holder.
